# EUROPÄISCHE PATENTSCHRIFT

(11) **EP 1 216 476 B1**
(45) Veröffentlichungstag und Bekanntmachung des Hinweises auf die Patenterteilung: **04.06.2003**
(21) Anmeldenummer: 00964114.3
(22) Anmeldetag: 05.09.2000
(51) Int. Cl.: G11C 7/24, H03K 3/356

(54) **SELBSTLÖSCHENDE SPEICHERZELLE**
SELF-ERASING MEMORY CELL
CELLULE DE MEMOIRE VOLATILE

(30) Priorität: 06.09.1999 DE 19942437
(43) Veröffentlichungstag der Anmeldung: 26.06.2002
(73) Patentinhaber: Giesecke & Devrient GmbH, 81677 München (DE)
(72) Erfinder: BRAUN, Wolfgang, 85579 Neubiberg (DE); WIREN, Arvid, 81927 München (DE)
(74) Vertreter: Klunker . Schmitt-Nilson . Hirsch
(86) Internationale Anmeldenummer: EP0008671
(87) Internationale Veröffentlichungsnummer: WO01018815

(56) Entgegenhaltungen:
- US-A- 4 484 088
- PATENT ABSTRACTS OF JAPAN vol. 014, no. 282 (E-0942), 19. Juni 1990 (1990-06-19) & JP 02 090669 A (NEC IC MICROCOMPUT SYST LTD), 30. März 1990 (1990-03-30)

## Beschreibung

Die Erfindung betrifft eine Vorrichtung zum sicheren Löschen einer flüchtigen Speicherzelle gemäß dem Oberbegriff des Anspruchs 1.

Die Fig. 5 zeigt beispielhaft den prinzipiellen Aufbau einer SRAM-Zelle. Diese SRAM-Zelle besteht im wesentlichen aus den beiden n-Kanal-Transistoren T1 und T2, wobei der Gate-Anschluß G1 des Transistors T1 an den Ausgang Q2 des Transistors T2 und der Gate-Anschluß G2 des Transistors T2 an den Ausgang Q1 des Transistors T1 rückgekoppelt sind. Die Source-Anschlüsse S1 und S2 der Transistoren T1 und T2 sind mit Masse verbunden. Die Drainanschlüsse D1 und D2 sind über die Widerstände R1 und R2 mit der Versorgungsspannung VCC verbunden. Vorzugsweise ist der Substrat- bzw. Bulk-Anschluß bei den beiden NMOS-Transistoren direkt mit dem Substrat verbunden. Die Widerstände R1 und R2 werden in der Praxis auf Chipebene durch je einen Transistor ersetzt.

Bedingt durch den Aufbau der RAM- oder SRAM-Zelle geht der Speicherinhalt nach Abschalten der Versorgungsspannung verloren. Aus diesem Grund werden in Geräten, in denen geheime Daten gespeichert werden, vorzugsweise RAM-Speicher verwendet. In Zahlungsverkehrsterminals werden Sicherheits-Module verwendet, bei denen die geheimen Schlüssel in batteriegepufferte RAM-Speicher abgelegt werden. Auch bei Chipkarten, in denen eine Batterie bzw. ein sonstiger Energiespeicher integriert ist, werden geheime Schlüssel oder sonstige geheime Daten in einem RAM-Speicher abgelegt, wobei vorzugsweise SRAMs verwendet werden.

Trotz der an und für sich günstigen Eigenschaft, daß der Speicherinhalt nach der Trennung von der Stromversorgung verloren geht, hat sich gezeigt, daß nicht alle in der RAM-Zelle gespeicherten Ladungsträger beim Ausschalten verloren gehen bzw. der Speicherlöschvotgang über eine Zeitspanne geht, in der ein Auslesen noch möglich ist.

Mit bekannten Analyseverfahren ist es überdies möglich, bereits anhand der verbleibenden Restelektronen auch noch an einer gelöschten Speicherzelle den Dateninhalt zu ermitteln. Dies kann verhindert werden, indem die Speicherzelle vor dem Abschalten mehrfach überschrieben wird. Zu diesem Zweck können Kondensatoren als Energiespeicher eingesetzt werden, die das mehrfache Überschreiben ermöglichen. Es besteht jedoch immer noch das Risiko, daß die Versorgungsspannung abgetrennt wird (auch der Energiespeicher), bevor die Mehrfachlöschung abgeschlossen ist.

Es ist deshalb Aufgabe der vorliegenden Erfindung, eine Vorrichtung zum sicheren Löschen einer flüchtigen Speicherzelle, insbesondere einer SRAM-Zelle anzugeben, bei der auch bei vollständiger Abtrennung der Versorgungsspannung ein sicheres Löschen ermöglicht wird, wobei der letzte Dateninhalt auch nicht anhand verbleibender Restelektronen ermittelbar sein soll.

Diese Aufgabe wird ausgehend von einer Vorrichtung nach dem Oberbegriff des Anspruchs 1 durch die kennzeichnenden Merkmale des Anspruchs 1 gelöst. Vorteilhafte Ausgestaltungen der Erfindung sind in den abhängigen Ansprüchen angegeben

Gemäß der Erfindung ist mindestens ein Schaltelement vorgesehen, welches bei Trennen der RAM-Zelle von der Versorgungsspannung in den leitenden Zustand geschaltet wird und die Ausgänge der Transistoren der RAM-Zelle kurzschließt. Durch die leitende Verbindung der komplementären Transistorausgänge, welche vorzugsweise auf Masse gelegt sind, wird in vorteilhafter Weise ein Potentialausgleich erzeugt, so daß alle noch verbleibenden Ladungsträger abfließen können und der vorherige Speicherinhalt damit nicht mehr ermittelbar ist.

Eine vorteilhafte Ausgestaltung der Erfindung sieht vor, daß das bzw. die Schaltelemente durch selbstleitende Transistoren realisiert sind. Diese Transistoren sind bei Anliegen der Versorgungsspannung im hochohmigen Zustand, d.h. im wesentlichen nichtleitend und gehen in den niederohmigen, d.h. leitenden Zustand über, sobald die Versorgungsspannung unterbrochen wird.

Die Erfindung wird im folgenden durch die Fig. 1 bis 5 erläutert. Es zeigen:
- Fig. 1a: eine selbstlöschende SRAM-Zelle (n-Kanal) mit p-Kanal Löschtransistoren,
- Fig. 1b: Schaltbild eines PMOS-Transistors bei Berücksichtigung der Substratdioden
- Fig. 1c: Schaltbild eines NMOS-Transistors bei Berücksichtigung der Substratdioden
- Fig. 2: eine selbstlöschende SRAM-Zelle (p-Kanal) mit n-Kanal Löschtransistoren,
- Fig. 3: eine selbstlöschende SRAM-Zelle (n-Kanal) mit n-Kanal Löschtransistoren,
- Fig. 4: eine selbstlöschende SRAM-Zelle (n-Kanal) mit n-Kanal Löschtransistoren und Spannungsüberwachung, und
- Fig. 5: eine Standard-SRAM-Zelle (n-Kanal).

Die Erfindung wird im folgenden ohne Beschränkung der Allgemeinheit an Hand einer SRAM-Zelle beschrieben.

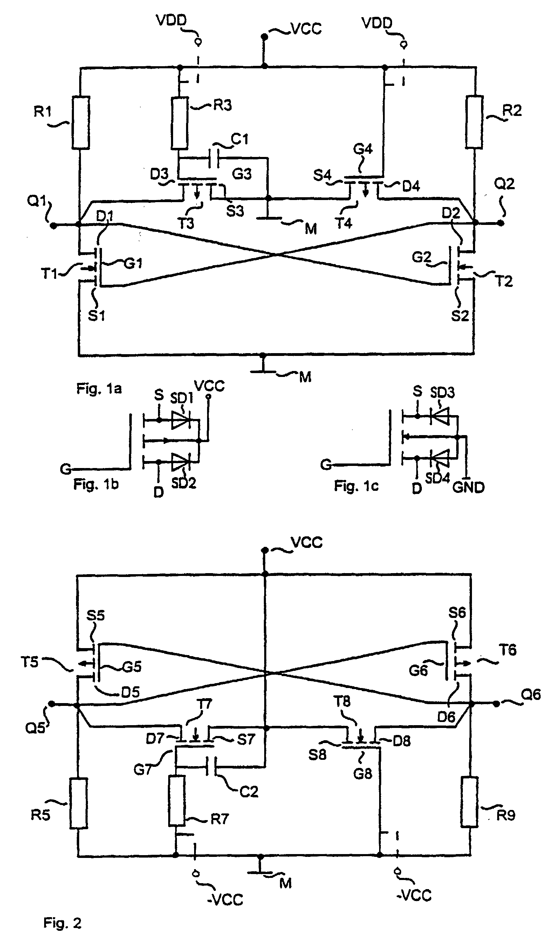

Die Fig. 1a beschreibt eine selbstlöschende SRAM-Zelle, deren Grundaufbau der SRAM-Zelle der Fig. 5 entspricht Um das Selbstlöschen der Speicherzelle im abgeschalteten Zustand zu erreichen, werden die beiden Transistoren T3 und T4 (selbstleitende p-Kanal MOS-FETs) hinzugefügt. Dabei wird der Drainanschluß D3 des Transistors T3 mit dem Ausgang Q1 des Transistors T1 verbunden. Der Source-Anschluß S3 des Transistors T3 wird mit dem Source-Anschluß S4 des Transistors T4 und der Masse M verbunden. Der Drainanschluß D4 des Transistors T4 wird an den Ausgang Q2 des Transistors T2 gelegt. Die Gate-Anschlüsse G3 und G4 der Transistoren T3 und T4 werden an die Versorgungsspannung VCC gelegt. In vorteilhafter Weise wird dabei der Gate-Anschluß G3 des Transistors T3 über eine RC-Kombination R3/C1 an die Versorgungsspannung VCC angeschlossen. Durch:die RC-Kombination wird ein definiertes Einschalten ermöglicht. Ohne Verwendung des RC-Gliedes muß auf die geeignete Dimensionierung der Transistoren geachtet werden.
Besonders vorteilhaft ist die direkte Verbindung der Gate-Anschlüsse G3 und G4 der Transistoren T3 und T4 an eine Versorgungsspannung VDD, die ein höheres Potential als VCC aufweist.

In Figur 1b ist ein PMOS-Transistor dargestellt, bei dem die Substratdioden SD1 und SD2 berücksichtigt sind. Diese Dioden ergeben sich fertigungsbedingt zwischen Substrat und eindotiertem Bereichen. Beim Design integrierter Schaltungen müssen diese pn-Übergänge berücksichtigt werden, was dazu führt, daß das Substrat der Schaltung je nach Technologie mit dem höchsten oder niedrigsten vorkommenden Spannungspotential verbunden werden muß. Die Steuerspannung zwischen Gateund Substratanschluß kann deshalb nur dann einen Potentialunterschied erreichen, wenn der Spannungswert am Gate G höher als VCC ist.

Für den in Fig. 1c dargestellten NMOS-Transistor gilt das entsprechend. Die Substratdioden werden mit D3 und D4 angegeben. Der Potentialunterschied wird dadurch erreicht, daß der Spannungswert am Gate niedriger als Masse liegt.

Die in den Fig. 1b und 1c gezeigten Schaltungen für die Transistoren mit eingetragenen Substratdioden haben auch für alle Transistoren der folgenden Figuren Gültigkeit.

Im Betrieb, d.h. wenn die Speicherzelle mit Spannung versorgt ist, werden die beiden Gateanschlüsse G3 und G4 der Transistoren T3 und T4 angesteuert und die Drain-Source-Übergänge (D3-S3 und D4-S4) werden hochohmig, d.h. im wesentlichen nicht leitend. Dadurch ist gewährleistet, daß der normale Betrieb der Speicherzelle ungehindert möglich ist und der Einfluß der zusätzlichen Beschaltung mit den Transistoren T3 und T4 vernachlässigbar ist. Die RC-Kombination verzögert das Umschalten des Transistors T3 in den hochohmigen Zustand, so daß ein definierter Einschaltzustand erreicht werden kann.

Bei Unterbrechung der Versorgungsspannung, d.h. bei Unterschreiten der Versorgungsspannung unter einen kritischen Wert werden die beiden Gateanschlüsse G3 und G4 der Transistoren T3 und T4 nicht mehr korrekt angesteuert und der jeweilige Drain-Source-Übergang des zugehörigen Transistors wird niederohmig, d.h. leitend, so daß die Ausgänge Q1 und Q2 der SRAM-Zelle kurzgeschlossen sind. Die niederohmige Verbindung der komplementären Ausgänge sowie die Masseverbindung ermöglicht einen Potentialausgleich, so daß alle noch verbleibenden Ladungsträger unmittelbar abfließen. Durch den Kurzschluß werden also alle noch vorhandenen Ladungsträger ausgemittelt, so daß ein auf die Zelle durchgeführter Angriff erfolglos ist.

Die Fig. 2 zeigt die Realisierung einer SRAM-Zelle mit p-Kanal-Transistoren. Es ist eine selbstlöschende SRAM-Zelle dargestellt, deren Aufbau grundsätzlich der SRAM-Zelle der Fig. 1 entspricht, wobei im Unterschied zur Fig. 1 p-Kanal-Transistoren T5 und T6 für die Speicherfunktion und n-Kanal-Transistoren T7 und T8 als Schaltelemente verwendet werden. Um das Selbstlöschen der Speicherzelle im abgeschalteten Zustand zu erreichen, werden analog zur Fig. 1 die beiden Transistoren T7 und T8 (selbstleitende n-Kanal MOS-FETs) hinzugefügt. Dabei wird der Drainanschluß D7 des Transistors T7 mit dem Ausgang Q5 des Transistors T5 verbunden. Der Source-Anschluß S7 des Transistors T7 wird mit dem Source-Anschluß S8 des Transistors T8 und der Versorgungsspannung VCC verbunden. Der Drainanschluß D8 des Transistors T8 wird an den Ausgang Q6 des Transistors T6 gelegt. Die Gate-Anschlüsse G7 und G8 der Transistoren T7 und T8 werden an Masse gelegt. In vorteilhafter Weise wird dabei der Gate-Anschluß G7 des Transistors T7 über eine RC-Kombination R7/C2 an Masse gelegt.

Hier hat es sich unter Berücksichtigung der pn-Übergänge vom Substrat auf die dotierten Bereiche als vorteilhaft erwiesen, die Gate-Anschlüsse G7 und G8 der Transistoren T7 und T8 direkt an eine negative Versorgungsspannung -VCC zu legen.

Die Ausgänge Q5 und Q6 der Transistoren T5 und T6 sind mit den Drain-Anschlüssen D7 des Transistors T7 und D8 des Transistors T8 verbunden.

Die Funktionsweise der SRAM-Zelle gemäß Fig. 2 entspricht im Wesentlichen der aus Fig. 1 mit umgekehrter Masse/Versorgungsspannungsbelegung.

Die Transistoren T7 und T8 befinden sich bei Anliegen der Versorgungsspannung im hochohmigen Zustand. Bei Unterschreiten eines Schwellwertes der Versorgungsspannung gehen diese Transistoren in den leitenden Zustand über, d.h. die Ausgänge Q5 und Q6 der Transistoren T5 und T6 werden kurzgeschlossen und an die Versorgungsspannung VCC gelegt, so daß die Restladungen abfließen können.

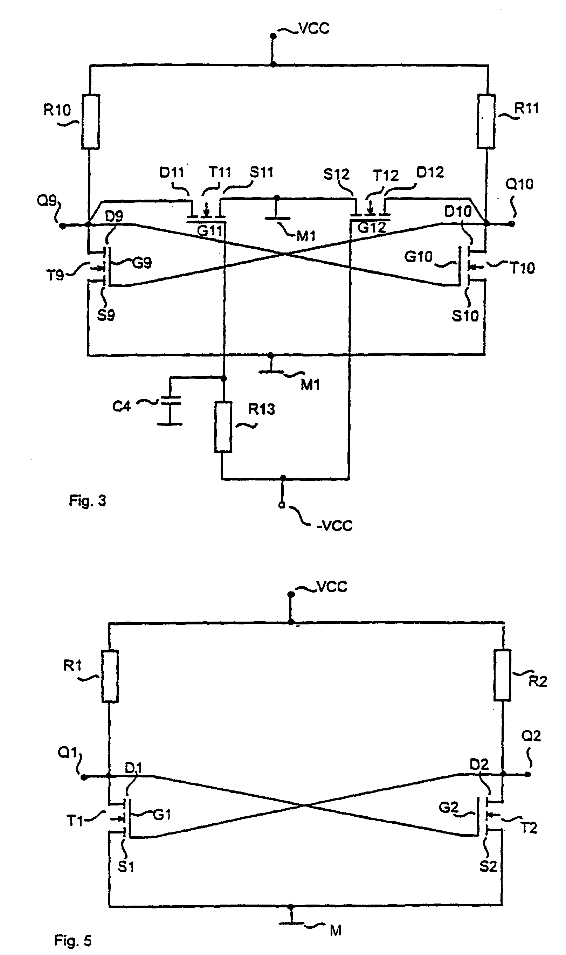

Die Figur 3 zeigt eine Ausführungsform der Erfindung mit n-Kanal (enhancementmode) MOS-FETs T9 und T10 als Transistoren einer Standard-SRAM-Zelle und n-Kanal (depletion-mode) MOS-FETs T11 und T12 mit negativer Gate-Ansteuerung als Löschtransistoren.

Das Selbstlöschen der Speicherzelle im abgeschalteten Zustand kann durch Hinzurügen von zwei selbstleitenden MOS-FETs T11 und T12, sowie die Erzeugung einer negativen Versorgungsspannung -VCC erreicht werden.

Die Drain-Anschlüsse D11 und D12 der beiden Transistoren T1 1 und T12 werden jeweils mit den Ausgängen Q9 und Q10 von T9 und T10 verbunden. Die Source-Anschlüsse S11 und S12 von T11 und T12 werden fest auf Masse M1 gelegt. Der Gate-Anschluß G11 des Transistors T11 wird direkt oder über eine RC-Kombination R13/C4 an die negative Versorgungsspannung -VCC angeschlossen, um ein definiertes Einschalten zu erzwingen. Der Gate-Anschluß G12 des Transistors T12 wird direkt mit der negativen Versorgungsspannung -VCC verbunden.

Entscheidend ist, daß eine negative Versorgungsspannung -VCC erzeugt wird, sobald die positive Versorgungsspannung VCC an der Schaltung anliegt.

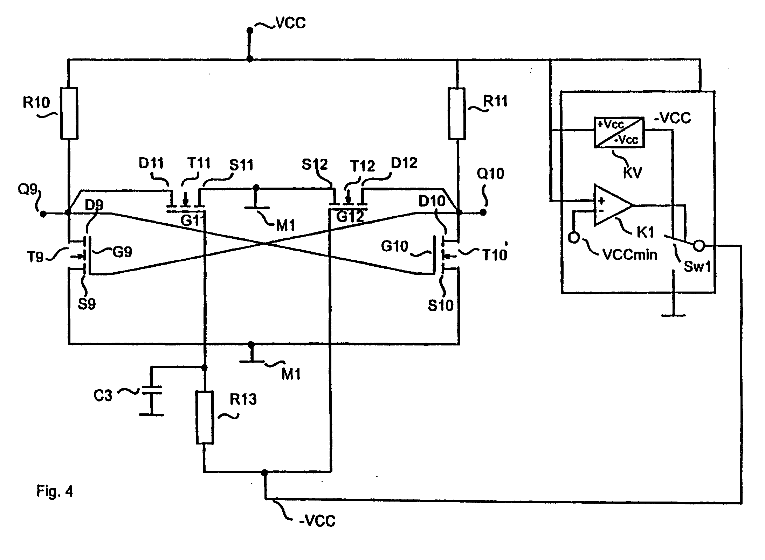

In der Praxis wird das Löschen der SRAM-Zelle durch diverse Sensoren aktiviert. Um die Funktion der gesamten Sensorik sicherzustellen, ist eine Spannungsüberwachung von VCC erforderlich, deren prinzipielle Funktionsweise in Figur 4 dargestellt ist, die sich lediglich durch Hinzufügen der Sensorik von Fig. 3 unterscheidet.

Bei Erreichen einer unteren Versorgungsspannung VCCmin, welche noch größer als die minimale Versorgungsspannung für die Gesamtschaltung sein muß, werden die Gates G11 und G12 der Transistoren T11 und T12 von -VCC auf Masse M1 geschaltet. Das Unterschreiten des Wertes VCCmin wird durch den Komparator K1 erkannt, welcher den Schalter SW1 umschaltet, wenn VCCmin unterschritten wird.

Die negative Spannungserzeugung, sowie die Schwellspannungserkennung darf nur einen sehr geringen Stromverbrauch, vorzugsweise weniger als 3µA benötigen, damit die SRAM-Zelle auch über längere Zeiträume (mehrere Jahre) aus einer Batterie versorgt werden kann.

Wird die Speicherzelle mit Spannung (VCC>VCCmin) versorgt, so werden die beiden Gates G11 und G12 der Transistoren T11 und T12 mit der negativen Versorgungsspannung -VCC angesteuert und die beiden Drain-Source-Übergänge D11-S11 und D12-S12 werden hochohmig. Dadurch ist gewährleistet, daß der normale Betrieb der Speicherzelle ungehindert möglich ist. Durch die RC-Kombination R13/C3 wird, soweit vorhanden das Umschalten in den hochohmigen Zustand am Transistor T11 verzögert, so daß ein definierter Einschaltzustand erreicht wird. Ohne Verwendung des RC-Gliedes kann dies auch durch geeignete Dimensionierung der Transistoren erreicht werden.

In dem Moment, in dem die Versorgungsspannung den kritischen Wert VCCmin unterschreitet, werden die beiden Gates G11 und G12 der Transistoren T11 und T12 nicht mehr negativ angesteuert, der jeweilige Drain-Source-Übergang des zugehörigen Transistors wird niederohmig, so daß die Ausgänge Q9 und Q10 der SRAM-Zelle quasi kurzgeschlossen werden.

Durch diese niederohmige Verbindung der komplementären Ausgänge untereinander und zusätzlich mit Masse findet ein Potentialausgleich statt, so daß alle noch verbleibenden Ladungsträger abfließen können. Ein auf diese Zelle durchgeführter Angriff wäre dann erfolglos.

## Patentansprüche

1. Vorrichtung zum sicheren Löschen einer vorzugsweise flüchtigen Speicherzelle, welche aus zwei Transistoren (T1, T2; T5, T6; T9, T10) aufgebaut ist, die jeweils mit dem Gate-Anschluß (G1, G2; G5, G6; G9, G10) an den Ausgang (Q1, Q2; Q5, Q6; Q9, Q10) des anderen Transistors rückgekoppelt ist, **dadurch gekennzeichnet, daß**
mindestens ein Schaltelement (T3, T4; T7, T8; T 11, T12) vorgesehen ist, welches beim Abschalten der Versorgungsspannung (VCC) in den leitenden Zustand übergeht und die Ausgänge (Q1, Q2; Q5, Q6; Q9, Q10) der Transistoren (T1, T2; T5, T6; T9, T10) kurzschließt und zusätzlich mit der Masse (M) oder der Versorgungsspannung (VCC/-VCC) verbindet.

2. Vorrichtung nach Anspruch 1, **dadurch gekennzeichnet, daß**
als Schaltelement bzw. als Schaltelemente Transistoren (T3, T4; T7, T8; T11, T12) verwendet werden.

3. Vorrichtung nach Anspruch 1 oder 2, **dadurch gekennzeichnet, daß** zumindest einer der Gateanschlüsse (G3, G4; G7, G8; G11, G12) über ein RC-Glied (R3/C1, R7/C2, R13/C3) mit der Versorgungsspannung (VCC, VDD), der Masse (M) bzw. der negativen Versorgungsspannung (-VCC) verbunden ist.

4. Vorrichtung nach einem der Ansprüche 1 bis 3, **dadurch gekennzeichnet, daß** die flüchtige Speicherzelle eine SRAM-Zelle ist.

5. Vorrichtung nach einem der Ansprüche 1 bis 4 **dadurch gekennzeichnet, daß** zur Überwachung der Versorgungsspannung ein oder mehrere Sensoren vorgesehen sind, welche einen Spannungsabfall erkennen.

6. Vorrichtung nach einem der Ansprüche 1 bis 5, **dadurch gekennzeichnet, daß** der Sensor einen Komparator (K1) enthält, welcher zum Vergleich des aktuellen Wertes der Versorgungsspannung (VCC) mit einem vorgegebenen Minimalwert (VCCmin) ausgelegt ist.

## Claims

1. An apparatus for reliably erasing a preferably volatile memory cell constructed of two transistors (T1, T2; T5, T6; T9, T10) each fed back with the gate terminal (G1, G2; G5, G6; G9, G10) to the output (Q1, Q2; Q5, Q6; Q9, Q10) of the other transistor, **characterized in that**
at least one switching element (T3, T4; T7, T8; T11, T12) is provided which goes to the conductive state upon disconnection of the supply voltage (VCC) and shorts the outputs (Q1, Q2; Q5, Q6; Q9, Q10) of the transistors (T1, T2; T5, T6; T9, T10) and additionally connects them with ground (M) or the supply voltage (VCC/-VCC).

2. An apparatus according to claim 1, **characterized in that** transistors (T3, T4; T7, T8; T11, T12) are used as a switching element or switching elements.

3. An apparatus according to claim 1 or 2, **characterized in that** at least one of the gate terminals (G3, G4; G7, G8; G11, G12) is connected via an RC module (R3/C1, R7/C2, R13/C3) with the supply voltage (VCC, VDD), ground (M) or the negative supply voltage (-VCC).

4. An apparatus according to any of claims 1 to 3, **characterized in that** the volatile memory cell is an SRAM cell.

5. An apparatus according to any of claims 1 to 4, **characterized in that** one or more sensors which detect a voltage drop are provided for monitoring the supply voltage.

6. An apparatus according to any of claims 1 to 5, **characterized in that** the sensor contains a comparator (K1) designed to compare the current value of the supply voltage (VCC) with a predetermined minimal value (VCCmin).

## Revendications

1. Procédé pour effacer de manière sûre une cellule mémoire, de préférence volatile, formée de deux transistors (T1, T2; T5, T6; T9, T10), qui sont chacun couplés rétroactivement avec le contact de grille (G1, G2; G5, G6; G9, G10) de la sortie (Q1, Q2 ; Q5, Q6; Q9, Q10) de l'autre transistor, **caractérisé en ce que**
il est prévu au moins un dispositif de commutation (T3, T4; T7, T8; T11, T12), lequel passe à l'état conducteur lors de la coupure de la tension d'alimentation (VCC) et court-circuite les sorties (Q1, Q2; Q5, Q6; Q9, Q10) des transistors (T1, T2; T5, T6; T9, T10) et de plus les relie avec la masse (M) ou la tension d'alimentation (VCC/-VCC).

2. Procédé selon la revendication 1, **caractérisé en ce que** le dispositif ou les dispositifs de commutation utilisés sont des transistors (T3, T4 ; T7, T8; T11, T12).

3. Procédé selon la revendication 1 ou 2, **caractérisé en ce qu'**au moins un des contacts de grille (G3, G4 ; G7, G8; G11, G12) est relié par un élément RC (R3/C1, R7/C2, R13/C3) à la tension d'alimentation (VCC, VDD), la masse (M) ou la tension d'alimentation négative (-VCC).

4. Procédé selon une des revendications 1 à 3, **caractérisé en ce que** la cellule mémoire volatile est une cellule SRAM.

5. Procédé selon une des revendications 1 à 4, **caractérisé en ce que** la surveillance de la tension d'alimentation est assurée par un ou plusieurs capteurs qui détectent une chute de tension.

6. Procédé selon une des revendications 1 à 5, **caractérisé en ce que** le capteur contient un comparateur (K1), lequel est conçu pour comparer la valeur actuelle de la tension d'alimentation (VCC) avec une valeur minimale prescrite (VCCmin).
